(19) **Europäisches Patentamt**
**European Patent Office**
**Office européen des brevets**

(11) **EP 3 896 813 B1**

(12) **EUROPEAN PATENT SPECIFICATION**

(45) Date of publication and mention
of the grant of the patent:
**27.11.2024 Bulletin 2024/48**

(21) Application number: **21176167.1**

(22) Date of filing: **25.01.2018**

(51) International Patent Classification (IPC):
*H02J 3/14* (2006.01)    *G01D 4/00* (2006.01)
*G06Q 50/06* (2024.01)    *H02J 13/00* (2006.01)
*H02J 3/00* (2006.01)

(52) Cooperative Patent Classification (CPC):
**G06Q 10/04; G06Q 10/06; G06Q 50/06;**
**H02J 3/003; H02J 3/14; H02J 13/00;**
**H02J 13/00004; H02J 13/00034;** G01D 4/004;
H02J 2310/12; Y02B 70/3225; Y04S 20/222

(54) **TECHNIQUES FOR MANAGING RESOURCE CONSUMPTION FOR DEMAND-BASED METERING**

TECHNIKEN ZUR VERWALTUNG DES RESSOURCENVERBRAUCHS ZUR
BEDARFSGERECHTEN DOSIERUNG

TECHNIQUES DE GESTION DE LA CONSOMMATION DE RESSOURCES POUR UN MESURAGE
BASÉ SUR LA DEMANDE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **25.01.2017 US 201762450190 P**

(43) Date of publication of application:
**20.10.2021 Bulletin 2021/42**

(62) Document number(s) of the earlier application(s) in
accordance with Art. 76 EPC:
**18703457.4 / 3 574 560**

(73) Proprietor: **Landis+Gyr Technology, Inc.**
**Alpharetta, GA 30022 (US)**

(72) Inventors:
• **NIEMI, Mikko**
**Alpharetta, 30022 (US)**
• **SHAW, David**
**Canton, 30115 (US)**

(74) Representative: **Marks & Clerk LLP**
**15 Fetter Lane**
**London EC4A 1BW (GB)**

(56) References cited:
**EP-A1- 0 003 010**    **WO-A1-2016/076008**
**US-A1- 2009 234 511**    **US-A1- 2016 329 707**
**US-A1- 2017 330 294**

**Description**

BACKGROUND

In some instances, electric utility providers meter customer usage based upon the electricity demand of individual customers over defined time intervals (also referred to as "demand intervals"). Often the utility providers bill such customers for their electricity demand using the peak demand value that occurred within a billing period. For example, a residential utility customer whose electricity demand during one 15-minute demand interval was 20 kilowatts (KW), while the remaining demand intervals for the monthly billing period were 5 KW would be billed for the month using their peak demand level of 20 KW. As a result, it may be advantageous for such customers to manage their electricity demand in order to avoid reaching an unnecessarily large peak demand level.

However, managing demand can be particularly challenging for customers who, in addition to the utility-provided electric power, have additional sources of electric power for their premises, such as photovoltaic solar cells, wind turbine generators, batteries, etc. Unlike the electric power provided by the electric utility, such additional power sources may vary in the amount of electric power that is provided, such as can occur with solar cells on a cloudy day or with a wind turbine during periods with little or no wind. Thus, even if the electricity consumed at a customer premise is steady, the electricity demand placed upon the utility by the customer can vary dramatically as utility-provided power is needed to offset the varying amount of power from the additional source(s). In order to avoid potentially costly peaks in metered demand usage, what is needed is a way to actively manage electricity usage that takes the metered demand into account.

WO 2016/076008 A1 describes a device, method, and program for controlling electrical power supply and demand. With that it is possible to create an appropriate plan for requesting a reduction in the amount of electrical power being purchased on the basis of an expectation value for the amount of reduced electrical power being purchased per consumer. The expectation value is determined on the basis of the remaining amount of storage cells for the consumer. An electrical power supply and demand control device has a remaining amount acquisition part and a setting part. The remaining amount acquisition part acquires remaining amount information indicating the remaining amount of storage cells for a consumer. The setting part sets an expectation value for the amount of reduced electrical power being purchased from a grid based on the consumer on the basis of the remaining amount information acquired by the remaining amount acquisition part.

In US 2017/330294 A1 is provided an electric power supply and demand control apparatus including a remaining battery level acquisition unit and a setting unit. The remaining battery level acquisition unit acquires remaining battery level information indicating a remaining battery level of a storage battery of a consumer. The setting unit sets an expectation value of a reduction in power purchase from a system performed by the consumer, on the basis of the remaining battery level information acquired by the remaining battery level acquisition unit. For example, a high expectation value is set for a consumer whose storage battery has a large remaining battery level. According to the present invention, it is possible to create an appropriate plan of a request for a reduction in a power purchase quantity, on the basis of the expectation value of the reduction in power purchase for each consumer determined on the basis of the remaining battery level of a storage battery of the consumer.

EP 0 003 010 A1 relates to a method and apparatus for limiting the power demand in heating-ventilation-air conditioning. A central control system includes a central processing unit (CPU) installed in a central location of a facility, and interconnected with a plurality of remote controllers, each located in an associated one of several buildings in the facility and each including a remote microprocessor (RMP) the CPU automatically controlling, simultaneously from the central location, the closed loop operation of individual environmental conditioning systems (ECS) in the several buildings comprising the facility in combination with the RMP associated therewith, and in dependence on the sensed temperature conditions within the living spaces associated with each system. A watt meter measures the total power usage of the facility in kilowatt hours (KWH) and provides signal information representative of the instantaneous power usage to an RMP associated therewith. The CPU receives the power usage signal information from the RMP, and provides in response thereto, a predicted peak average power demand signal value in each demand interval of time over which the usage is monitored by the electric utility. The CPU compares the predicted peak average power demand signal with a monthly demand limit (MDL) signal and provides in response to a predicted signal value greater than the MDL value, load shed command signals to each of the RMPs associated with ECS, each RMP providing a turn off of selected one, or all of the ECS associated therewith, in dependence on the load shed command signals from the CPU.

US 2009/234511 A1 describes a demand control device. The demand control device includes a predicted value calculating unit arranged to calculate a predicted value of a power consumption integrated value for each one of a plurality of demand time intervals including a current demand time interval and a predetermined number of demand time intervals subsequent to the current demand time interval based on performance data stored in a power database at the start of the demand time interval, and a control unit arranged to control appliances based on the predicted value calculated by the predicted value calculating unit for each one of the plurality of demand time intervals and on a pre-set target value.

US 2016/329707 A1 relates to peak shaving using energy storage. Methods for controlling an energy storage device to reduce peak power demand at a site are provided. In one embodiment, load data corresponding to a load in a utility grid-connecting energy generation (EG) system is received. The load data may be sampled at a first predetermined interval, and the EG system may include an energy storage device. A load threshold level is received, and a discharge control signal is generated. The discharge control signal may be generated when the measured load is at or above the load threshold level. The control signal may be applied to the measured load for a second predetermined interval that is longer than the first predetermined interval.

DESCRIPTION OF THE INVENTION

Embodiments of the present invention are generally directed to a meter that manages electricity usage for a utility customer based on the metered demand. In an exemplary embodiment, an electricity meter determines a value for a customer's electricity demand during defined demand intervals using an application or other logic executing in the electricity meter (sometimes referred to as the "Demand Manager" application). In the event that that the demand exceeds a limit that the customer has set, the meter will start shedding the electrical load by issuing corresponding commands to the customer's load control devices, such as thermostats and load control switches. Once the meter has issued one or more load-reducing commands, it monitors the resulting electricity demand to determine if the demand has been reduced to a level to stay within the customer-configured limits for the demand interval. If the electricity demand still seems to exceed the limit (or is forecasted to exceed the limit), the meter issues additional load-reducing commands to further reduce the customer's electricity demand for utility-provided electric power. In some instances, a customer's demand for utility-provided electric power is determined not only by their amount of electricity consumption, but also by the amount of electricity supplied to their premise by additional power sources, such as photovoltaic solar cells, wind turbine generators, batteries, etc. In some embodiments, the meter measures demand and usage that is in excess of the electrical power supplied by the additional power sources (sometimes referred to as "net demand" and "net usage," respectively).

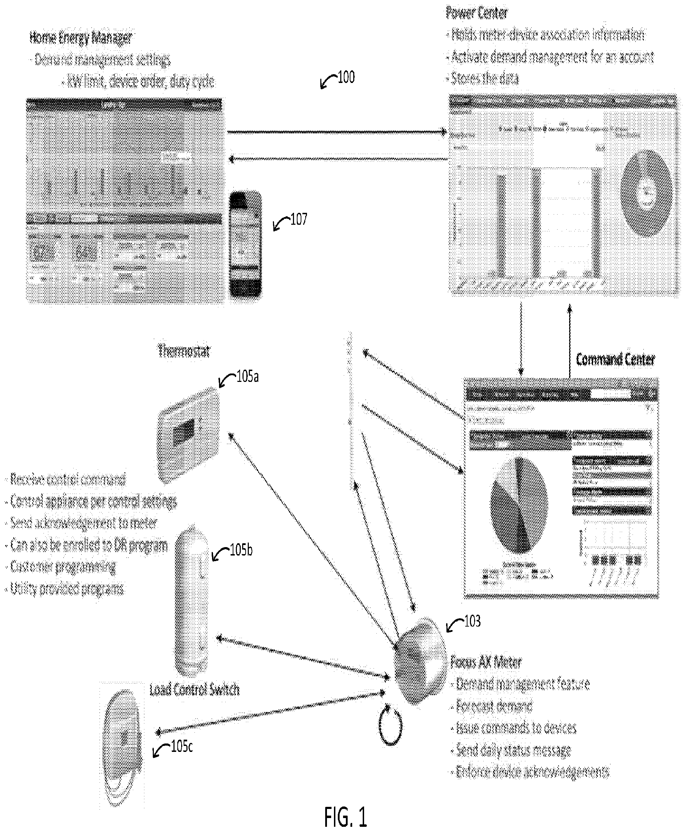

With reference to FIG. 1, shown is an exemplary metered environment 100 in which a utility customer can manage her or his electricity demand. The metered environment 100 includes an electricity meter 103 that meters electricity demand and usage for a customer premise. The metered environment 100 also includes various electrical load managing devices, such as a thermostat 105a and load control switches 105b-c, that are capable of adjusting (i.e., shedding and/or restoring) electricity usage of other on-premise devices to affect demand. For example, the thermostat 105a may manage temperature set points and other operating modes of a heat pump for a home, while a load control switch 105b-c may manage operation of a vehicle charger, clothes dryer, water heater, etc. The load managing devices 105 can receive commands from the meter 103 to shed and/or restore electrical load. The meter may communicate with the load managing devices 105 using Wi-Fi; RF mesh networking, such as defined by ZigBee and/or IEEE 802.15.4; Z-Wave; Power-line Communication (PLC); and/or other communication technologies and protocols. In some embodiments, the metered environment 100 also includes additional power sources (not shown), such as photovoltaic solar cells, wind turbine generators, batteries, etc., that provide power for a customer premise, in addition to the utility-provided power that is metered by the meter 103. In still other embodiments, a metering device that implements the Demand Manager application, such as the meter 103, may be placed at the transformer level of the utility provider, thereby enabling electricity demand management for possibly multiple customers within a geographic area.

A utility customer may manage configuration of the electricity demand management functionality of the meter 103 using a computing device 107, such as a smartphone, desktop computer, laptop computer, etc. The computing device 107 may communicate directly with the meter 103 via Wi-Fi and/or other communication protocols, or the customer may configure their meter 103 indirectly via a cloud computing interface. The electric utility provider may also communicate with the meter 103 to obtain and/or configure various data on the meter, such as data associated with electricity usage and demand. For example, a utility provider may configure the length of demand intervals (e.g., 15 min., 30 min., or 60 min.) during which electricity demand for a customer is evaluated, the various billing rates that correspond to when/how demand should be tracked and how it is to be billed, etc. For instance, billing rate A may correspond to demand-based pricing and the utility provider schedules rate A to be in effect from 5 P.M. to 10 P.M. Monday-Friday, whereas the remainder of the time billing rate B is in effect whereby electricity is billed based on usage and demand is not considered. When the utility provider seeks to change schedules or other aspects associated with customer billing, this data is stored by the meter 103 where it may be used to inform electricity demand/usage decisions according to the portion of the configuration made by the customer.

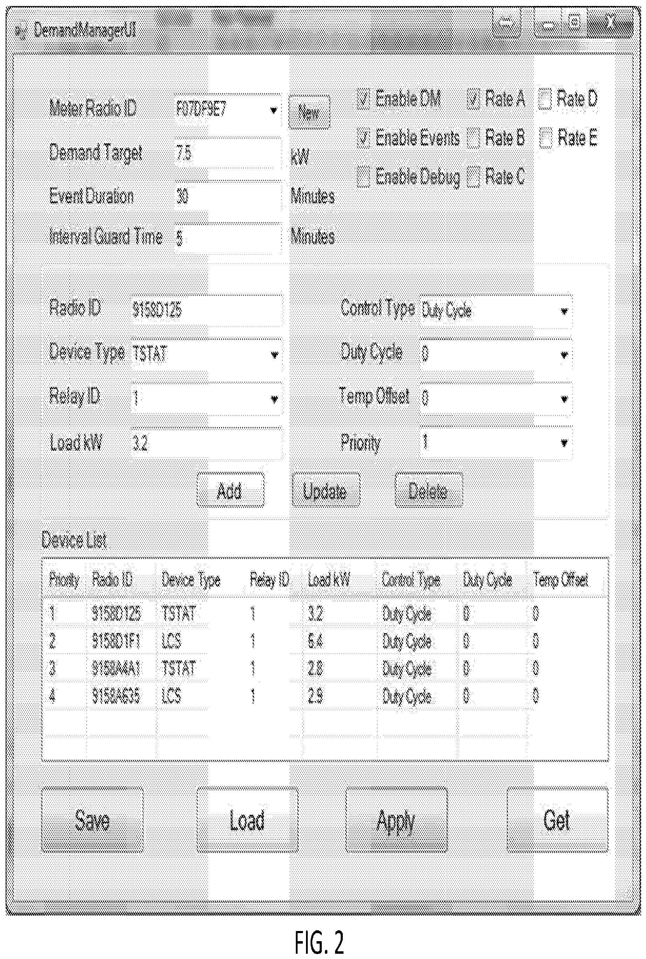

Shown in FIG. 2, is an exemplary user interface for an application with which a customer may configure the electricity demand management functionality of their meter 103 using a computing device 107. In some embodiments, a portion of the parameters shown in the user interface may be configured by the utility provider and may or may not also be configurable by the customer. The tables below further describe the possible parameters presented in the user interface.

| Application Parameter | Description |
|---|---|
| Meter Radio ID | The radio ID of the meter running Demand Manager |
| Demand Target | Specifies the forecasted demand threshold at which Demand Manager will shed load.<br><br>In addition, Demand manager will cancel load control for a device if it calculates the forecasted demand will remain below the target with the load re-enabled (utilizing the devices "Load kW" value). |
| Event Duration (also referred to as Demand Interval) | Specifies the duration for the load shed command.<br><br>Typical value is 15, 30, or 60 minutes. May be set by the utility provider or adjusted/specified by a customer for demand management purposes. |
| Interval Guard Time | Specifies the length of time at the start of each interval during which Demand Manager will not consider shedding load. Typical value is 5 minutes. |
| Enable DM | Enables the Demand Manager Feature in the Meter |
| Enable Events | Enables the reporting of events in Demand Manager. Events are generated and sent after a load control command is issued to a device.<br>It is recommended that this feature be enabled during the pilot. |
| Enable Debug | Enables the reporting of debug messaging in Demand Manager. The debug message is sent every 20 seconds from the meter to Load Control Shop to indicate the operational status of the Demand Manager application. |
| Enable Rate A,B,C,D,E | Specifies for which rates in the meter that Demand Manager should actively control demand. Details about each rate, such as schedule (days, times, etc.) and pricing, are defined by the utility provider and are subject to be updated periodically.<br>The meter can utilize the most current rate information configured by the utility provider for performing demand management functions. |

The table below further describes possible parameters for load control devices that may be managed by the meter 103 to shed and/or restore electrical load.

| Per Device Parameters | Description |
|---|---|
| Radio ID | The 4 byte serial number of the SBR radio in the load control device. |
| Device Type | Supported Types:<br>TSTAT - Gridstream Thermostat<br>LCS - Gridstream Load Control Switch |
| Relay ID | Specifies the relay to be configured on a Load Control Switch Supported Values:<br>For Thermostat - always 1<br>For LCS - 1 or 2 |
| Load kW | Specifies the size of the load under control in KW. This value will be used by Demand Manager to determine if an active load shed can be canceled for device and still maintain the demand target. |
| Control Type | Specifies the type of load control when shedding load Supported Types:<br>Duty Cycle - Shed load using Duty cycle method<br>Temp Offset - Shed load using temperature offset method |
| Duty Cycle | Specifies the maximum operational duty cycle of the device when shedding load with the "Duty Cycle" control type. Examples:<br><br>- Duty Cycle of "0" indicates that the load will remain off for the duration of the event. |

(continued)

| Per Device Parameters | Description |
|---|---|
| | - Duty Cycle of "70" specifies that the load will be allowed to run for at most 70% of the event duration. This value is ignored for the "Temp Offset" control type. |
| Temp Offset | Specifies the set point offset adjustment in degrees F when shedding load with the "Temp Offset" control type. This value is ignored for the "Duty Cycle" control type. |
| Priority | Specifies the order in which loads should be shed. Priority 1 is shed first. Typical values: 1 to 16 |

In some embodiments, when the meter 103 is appropriately configured, Demand Manager will make decisions to shed or restore electrical load based on the results of the calculated forecasted demand and the configured demand target. The inputs to this calculation include the following metrics which can be provided by the metrology module in the meter:

- CurrentDemandKWH - Total energy accumulated in the current interval

- InstantaneousKW - Current instantaneous power measured by the meter

- IntervalLength - Demand Interval length (in seconds)

- TimeLeft - Amount of time remaining in the interval (in seconds)

The equation for forecasted demand is given as follows:

$$DemandForecastKW$$

$$= \frac{CurrentDemandKWH * 3600}{(IntervalLength - TimeLeft)} * \frac{(IntervalLength - TimeLeft)}{IntevalLength}$$

$$+ InstantKW * \frac{TimeLeft}{IntervalLength}$$

Which simplifies to the form::

$$DemandForecastKW = \frac{(CurrentDemandKWH * 3600) + (InstantKW * TimeLeft)}{IntevalLength}$$

The forecasted demand estimates the demand value for the current demand interval, taking into account the demand thus far for the interval and assuming the instantaneous demand will continue for the remainder of the interval. It should be noted that in other embodiments, the meter 103 can make decisions based on other demand values, such as instantaneous demand, rather than forecasted demand.

Demand Manager business logic is controlled by the following configurable values:

- Demand Target - Specifies the desired kw demand value to which Demand Manager should manage via shed and restoration of loads
- Interval Guard Time - Specifies the length of time at the start of each interval during which Demand Manager will not consider shedding load

- Control Event Length - Specifies the default length of time that demand manager will issue events when controlling load
- Load KW - Specifies the amount of demand for each load configured to demand manager. Demand manager utilizes this value to determine if restoring a load will still maintain the demand forecast below demand target
- Rate Flags - Specifies during which rate periods that Demand Manager should consider shedding load

**Use Cases**

Below are possible use cases for the meter 103 configured for managing electricity demand (via Demand Manager) under the following configuration:

| Demand Target | 10 KW |
|---|---|
| Rate Flags | Rate A |
| Interval Guard Time | 5 Minutes |
| Load1 kW | 3 KW |
| Load2 kW | 4 KW |
| Load3 kW | 8 KW |
| Load4 KW | 2 KW |
| Meter Demand Interval Size | 30 minutes |

**Use Case: No load shed during disabled rate periods**

- Conditions

  ◦ Meter is currently accumulating for billing Rate B (in which demand is not billed)
  ◦ Demand Forecast is 12 KW

- Expected Behavior
  ◦ Demand Manager will not shed load even though Demand Forecast > Demand Target since Rate B is not enabled for Demand Manager

**Use Case: No load shed when Demand Forecast < Demand Target**

- Conditions

  ◦ Meter is currently accumulating for billing Rate A
  ◦ Demand Forecast is 8 KW and remains < Demand Target during the interval

- Expected Behavior
  ◦ Demand Manager will not shed load because Demand Forecast < Demand Target

**Use Case: No load shed when Demand Forecast > Demand Target during Interval Guard Time**

- Conditions

  ◦ Meter is currently accumulating for billing Rate A
  ◦ Demand Forecast is 12 KW at 3 minutes into interval

◦ Demand Forecast becomes 9 KW at 5 minutes into the interval
◦ Demand Forecast remains below Demand Target for remainder of interval

- Expected Behavior
  ◦ Demand Manager will not shed load even though Demand Forecast > Demand Target as this occurred only during the Interval Guard Time during which the Demand Forecast can exceed the Demand Target without load being shed

**Use Case: Load shed when Demand Forecast > Demand Target**

- Conditions

  ◦ Meter is currently accumulating for billing Rate A
  ◦ Demand Forecast is 9 KW at 5 minutes into interval
  ◦ Demand Forecast becomes 14 KW at 10 minutes into the interval

- Expected Behavior

  ◦ Demand Manager will shed load1 at 10:00 into the interval
  ◦ Demand Manager will see Demand Forecast drops to 12 KW at 10:10 into interval
  ◦ Demand Manager will shed load2 at 10:20 into the interval
  ◦ Demand Manager will see Demand Forecast drops to 9.3 KW at 10:30 into interval
  ◦ Demand Manager will not shed any more load as long as Demand Forecast remains below Demand Target for the remainder of the interval
  ◦ The Loads will automatically exit the load control 30 minutes after the load shed started (as the next Demand Interval begins with the Interval Guard Time).

**Use Case: Load restoration when Demand Forecast < Demand Target**

- Conditions

  ◦ Meter is currently accumulating for billing Rate A
  ◦ Demand Forecast had put all four loads into control due to exceeding demand target
  ◦ Demand Forecast remains at 9 KW throughout the interval

- Expected Behavior

  o Demand Manager will continually be evaluating whether restoration of load(s) will maintain the demand target constraint
  ◦ At 10:00 into the interval none of the loads can be restored. Calculations

    ▪ ForecastedDemand + Loadl = 9KW + 3KW*20min/30min = 11.0 KW
    ▪ ForecastedDemand + Load2 = 9KW + 4KW*20min/30min = 11.6 KW
    ▪ ForecastedDemand + Load3 = 9KW + 8KW*20min/30min = 14.3 KW
    ▪ ForecastedDemand + Load4 = 9KW + 5KW*20min/30min = 12.3 KW

  ◦ At 15:00 into the interval none of the loads can be restored. Calculations

    ▪ ForecastedDemand + Loadl = 9KW + 3KW*15min/30min = 10.5 KW
    ▪ ForecastedDemand + Load2 = 9KW + 4KW*15min/30min = 11.0 KW
    ▪ ForecastedDemand + Load3 = 9KW + 8KW*15min/30min = 13 KW
    ▪ ForecastedDemand + Load4 = 9KW + 5KW*15min/30min = 11.5 KW

  ◦ At 21:00 into the interval, Demand Manager will determine that Load1 can be restored. Calculations:

- ForecastedDemand + Load1 = 9KW + 3KW*9min/30min = 9.9 KW
- ForecastedDemand + Load2 = 9KW + 4KW*9min/30min = 10.2 KW
- ForecastedDemand + Load3 = 9KW + 8KW*9min/30min = 11.4 KW
- ForecastedDemand + Load4 = 9KW + 5KW*9min/30min = 10.5 KW

  ◦ At 21:00 demand manager will end the control event on Load1
  ◦ At 21:10 demand manager will see Demand Forecast increased to 9.9 KW

To generalize the above use cases, an exemplary meter 103 may perform the various tasks of Demand Manager using the following business logic:

| Tasks | Frequency |
| --- | --- |
| Evaluate Demand<br><br>- Creates a Forecasted Demand value derived from the following meter read data:<br>    ◦ watthours accumulated in the current demand interval<br>    ◦ Instantaneous KW<br>    ◦ time remaining in the interval<br>    ◦ Programmed demand interval size.<br>- Forecasted Demand mathematically is equivalent to the | Every 20 seconds |
| interval's demand if the current instantaneous demand remained constant for the remainder of the demand interval.<br>- The direction of the power flow is known to the meter. The meter does not accumulate energy in the demand register whenever the meter is receiving energy. Likewise, the Forecasted Demand will reflect negative kW as an instantaneous power of zero.<br>- If Forecasted Demand > Demand Target then Demand Manager will:<br>    ◦ Enable task to shed load<br>    ◦ Disable task to cancel shed load<br>- If Forecasted Demand < Demand Target then Demand Manager will:<br>    ◦ Enable task to cancel shed load<br>    ◦ Disable task to shed load | |
| Shed Load<br>- While this task is active and if the current rate is enabled in the DM configuration, DM will send a load shed command to the next device in the load control device list that is not currently shedding load<br>- Selects devices in priority order<br>- Delays at least 30 seconds between each load shed command allowing for time to re-evaluate the Forecasted Demand before issuing subsequent load commands<br>- The DM configuration specifies the parameters in the load control command (duration, relay ID, duty cycle / temp offset) | Evaluates every 30 seconds |
| Cancel Shed Load<br>- While this task is active, DM will cancel load shed to devices if<br>    ◦ The device is in control<br>    ◦ A calculation of forecasted demand with the load active (using the configured load kW value) is still below the demand target<br>- Selects devices in reverse priority order<br>- Delays at least 30 seconds between each load cancel command | Evaluates every 30 seconds |
| Send Debug Message | Every 20 seconds |

(continued)

| | |
|---|---|
| - If enabled in the DM configuration, this message is sent to the HES whenever the Demand Forecast is evaluated | |
| Send Event Message<br><br>    - If enabled in the configuration, this message is sent to the HES after load control command is executed | After every load control command |

When the meter 103 is configured to generate event messages, the messages may contain information such as shown in the table below:

| Element | Description |
|---|---|
| Timestamp | Timestamp when the event record was created in 1 second resolution |
| Event Log ID | Event Record Counter value.<br>Incremented for each created event log record |
| Event Reason | Specifies the reason for the event record.<br>Values include:<br>DM_EVENTREASON_STARTDRLC equ 1<br>DM_EVENTREASON_STOPDRLC equ 2<br>DM_EVENTREASON_INTERVAL equ 3 |
| Pre-Time Remaining | Prior to issuing the load control command, the time remaining in seconds for the demand interval |
| Pre-Forecast Demand | Prior to issuing the load control command, the calculated forecast demand in watts. |
| Pre-Instantaneous kW | Prior to issuing the load control command, the measured instantaneous KW measured by the meter in watts. |
| Post-Time Remaining | Subsequent to issuing the load control command, the time remaining in seconds for the demand interval |
| Post-Forecast Demand | Subsequent to issuing the load control command, the calculated forecast demand in watts. |
| Post-Instantaneous kW | Subsequent to issuing the load control command, the measured instantaneous KW measured by the meter in watts. |
| CE Flags | Indicates which devices are currently in control.<br>Two byte mask. 0x01 = Device 1, 0x02 = Device2, etc. |
| Demand Target | The currently configured demand target in watts |
| Event Duration | The currently configured event duration in minutes |
| DRLC Count | Counter indicating the total number of DRLC commands sent by Demand Manager |
| DRLC Response | Indicates if the device acknowledges the load control command.<br>DM_DRLC_RESPONSE_ACK equ 0<br>DM_DRLC_RESPONSE_NONE equ 1<br>DM_DRLC_RESPONSE_UNKNOWN equ 255 |
| DRLC Radio ID | Radio ID for the device being controlled |
| DRLC Parameters | Specifies the configured parameters for controlled device including:<br>Load Type<br>Control Type<br>Temp Offset / Duty Cycle setting |

The foregoing is provided for purposes of illustrating, describing, and explaining aspects of the present invention and is not intended to be exhaustive or to limit the invention to the precise forms disclosed. Further modifications and adaptation of these embodiments will be apparent to those skilled in the art and may be made without departing from the scope of the invention. Different arrangements and combinations of the components and functionality described above, as well as those not shown or described are possible. Similarly, some features and sub-combinations are useful and may be employed without reference to other features and sub-combinations. Embodiments of the invention have been described for illustrative and not restrictive purposes, and alternative embodiments will become apparent to readers of the appended claims defining the scope of the present invention.

**Claims**

1. A system for managing electrical consumption of a load device (306), the system including:

   a load managing device (105) capable of adjusting the electrical consumption of the load device (306), and
   a processor configured with code to perform operations comprising:

   receiving information describing a quantity of electricity received by the load device (306) from an electrical utility provider (120);
   determining that the portion of the received energy is received during a local demand interval (312), wherein the local demand interval (312) has i) a local duration and a local start time that are modified based on a provider duration of a provider demand interval (322) associated with the electrical utility provider (120) and ii) an interval guard time at a start of the local demand interval, wherein the processor does not consider shedding load during the guard time;
   determining a forecasted consumption (314) of the load device (306) based on the portion of the received energy received during the local demand interval (312) and on a quantity of time remaining in the local duration of the local demand interval (312);
   based on a comparison of the forecasted consumption (314) to a demand threshold (316) associated with the local demand interval (312), determining that the forecasted consumption (314) exceeds the demand threshold (316); and
   responsive to determining that the forecasted consumption (314) exceeds the demand threshold, adjusting the electrical consumption of the load device (306) unless the forecasted consumption exceeds the demand threshold only during the guard interval.

2. The system of claim 1, wherein:

   the information describing the provider demand interval (322) indicates a billing category of the provider demand interval (322), and
   the demand threshold (316) associated with the local demand interval (312) is determined based on the billing category.

3. The system of claim 1, wherein adjusting the electrical consumption of the load device (306) includes reducing the electrical consumption of the load device (306).

4. The system of claim 1, wherein the processor is further configured for:

   determining that an additional forecasted consumption (314) of the load device (306) is within the demand threshold (316), and
   responsive to determining that the additional forecasted consumption (314) is within the demand threshold (316), issuing an additional command to the load managing device (105), wherein the additional command describes an increase of the electrical consumption by the load device (306).

**Patentansprüche**

1. System zum Verwalten eines elektrischen Verbrauchs einer Lastvorrichtung (306), wobei das System Folgendes einschließt:

   eine Lastverwaltungsvorrichtung (105), die in der Lage ist, den Stromverbrauch der Lastvorrichtung (306) anzupassen, und

einen Prozessor, der mit Code konfiguriert ist, um Vorgänge durchzuführen, die Folgendes umfassen:

Empfangen von Informationen, die eine von der Lastvorrichtung (306), von einem öffentlichen Stromversorger (120) aus, empfangene Strommenge beschreiben,

Bestimmen, dass der Anteil der empfangenen Energie während eines lokalen Bedarfszeitraums (312) empfangen wird, wobei der lokale Bedarfszeitraum (312) i) eine lokale Dauer und eine lokale Startzeit, die auf der Grundlage einer Versorgerdauer eines Versorgerbedarfszeitraums (322) modifiziert werden, der dem öffentlichen Stromversorger (120) zugeordnet ist, und ii) eine Zeitraumschutzzeit zu Beginn des lokalen Bedarfszeitraums hat, wobei der Prozessor ein Abwerfen von Last während der Schutzzeit nicht in Betracht zieht;

Bestimmen eines prognostizierten Verbrauchs (314) der Lastvorrichtung (306) basierend auf dem Anteil der empfangenen Energie, der während des lokalen Bedarfszeitraums (312) empfangen wird, und auf einer Zeitmenge, die in der lokalen Dauer des lokalen Bedarfszeitraums (312) verbleibt;

basierend auf einem Vergleich des prognostizierten Verbrauchs (314) mit einer Bedarfsschwelle (316), die dem lokalen Bedarfszeitraum (312) zugeordnet ist, Bestimmen, dass der prognostizierte Verbrauch (314) die Bedarfsschwelle (316) überschreitet; und

als Reaktion auf das Bestimmen, dass der prognostizierte Verbrauch (314) die Bedarfsschwelle überschreitet, Anpassen des Stromverbrauchs der Lastvorrichtung (306), es sei denn, der prognostizierte Verbrauch überschreitet die Bedarfsschwelle nur während des Schutzintervalls.

2. System nach Anspruch 1, wobei:

die Informationen, die den Versorgerbedarfszeitraum (322) beschreiben, eine Abrechnungskategorie des Versorgerbedarfszeitraums (322) angeben, und

die dem lokalen Bedarfszeitraum (312) zugeordnete Bedarfsschwelle (316) basierend auf der Abrechnungskategorie bestimmt wird.

3. System nach Anspruch 1, wobei das Anpassen des Stromverbrauchs der Lastverwaltungsvorrichtung (306) das Verringern des Stromverbrauchs der Lastvorrichtung (306) einschließt.

4. System nach Anspruch 1, wobei der Prozessor ferner für Folgendes konfiguriert ist:

Bestimmen, dass ein zusätzlicher prognostizierter Verbrauch (314) der Lastvorrichtung (306) innerhalb der Bedarfsschwelle (316) liegt, und

als Reaktion auf das Bestimmen, dass der zusätzliche prognostizierte Verbrauch (314) innerhalb der Bedarfsschwelle (316) liegt, Ausgeben eines zusätzlichen Befehls an die Lastverwaltungsvorrichtung (105), wobei der zusätzliche Befehl eine Erhöhung des Stromverbrauchs durch die Lastvorrichtung (306) beschreibt.

**Revendications**

1. Système de gestion d'une consommation électrique d'un dispositif de charge (306), le système incluant :

un dispositif de gestion de charge (105) capable d'ajuster la consommation électrique du dispositif de charge (306), et

un processeur configuré avec du code pour effectuer des opérations comprenant :

la réception d'informations décrivant une quantité d'électricité reçue par le dispositif de charge (306) en provenance d'un fournisseur de services publics d'électricité (120) ;

la détermination que la partie de l'énergie reçue est reçue pendant un intervalle de demande locale (312), dans lequel l'intervalle de demande locale (312) possède i) une durée locale et une heure de début locale qui sont modifiées sur la base d'une durée de fournisseur d'un intervalle de demande de fournisseur (322) associé au fournisseur de services publics d'électricité (120), et ii) une heure de garde d'intervalle à un début de l'intervalle de demande locale, dans lequel le processeur n'envisage pas de délester une charge pendant le temps de garde ;

la détermination d'une consommation prévue (314) du dispositif de charge (306) sur la base de la partie de l'énergie reçue qui est reçue pendant l'intervalle de demande locale (312) et d'une quantité de temps restant dans la durée locale de l'intervalle de demande locale (312) ;

sur la base d'une comparaison de la consommation prévue (314) à un seuil de demande (316) associé à l'intervalle de demande locale (312), la détermination du fait que la consommation prévue (314) dépasse le seuil de demande (316) ; et

en réaction à la détermination que la consommation prévue (314) dépasse le seuil de demande, l'ajustement de la consommation électrique du dispositif de charge (306) à moins que la consommation prévue ne dépasse le seuil de demande que durant l'intervalle de garde.

2. Système selon la revendication 1, dans lequel :

les informations décrivant l'intervalle de demande de fournisseur (322) indiquent une catégorie de facturation de l'intervalle de demande de fournisseur (322), et

le seuil de demande (316) associé à l'intervalle de demande locale (312) est déterminé sur la base de la catégorie de facturation.

3. Système selon la revendication 1, dans lequel l'ajustement de la consommation électrique du dispositif de charge (306) inclut la réduction de la consommation électrique du dispositif de charge (306).

4. Système selon la revendication 1, dans lequel le processeur est en outre configuré pour :

déterminer qu'une consommation prévue supplémentaire (314) du dispositif de charge (306) se situe à l'intérieur du seuil de demande (316), et

en réponse à la détermination du fait que la consommation prévue supplémentaire (314) se situe à l'intérieur du seuil de demande (316), émettre une commande supplémentaire au dispositif de gestion de charge (105), la commande supplémentaire décrivant une augmentation de la consommation électrique du dispositif de charge (306).

**Home Energy Manager**
- Demand management settings
  - kW limit, device order, duty cycle

**Power Center**
- Holds meter-device association information
- Activate demand management for an account
- Stores the data

100

107

**Thermostat**

105a

- Receive control command
- Control appliance per control settings
- Send acknowledgement to meter
- Can also be enrolled to DR program
- Customer programming
- Utility provided programs

105b

**Load Control Switch**

105c

**Command Center**

103

**Focus AX Meter**
- Demand management feature
- Forecast demand
- Issue commands to devices
- Send daily status message
- Enforce device acknowledgements

FIG. 1

FIG. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016076008 A1
- US 2017330294 A1
- EP 0003010 A1
- US 2009234511 A1
- US 2016329707 A1